# EUROPÄISCHE PATENTSCHRIFT

(11) **EP 0 931 341 B1**
(45) Veröffentlichungstag und Bekanntmachung des Hinweises auf die Patenterteilung: **19.12.2001**
(21) Anmeldenummer: 97909129.5
(22) Anmeldetag: 11.09.1997
(51) Int. Cl.: H01L 21/8247, H01L 27/115, H01L 21/8242, H01L 27/108, H01L 21/3205

(54) **VERFAHREN ZUR HERSTELLUNG BARRIERENFREIER HALBLEITERSPEICHERANORDNUNGEN**
PROCESS FOR PRODUCING BARRIER-FREE SEMICONDUCTOR STORAGE ASSEMBLIES
PROCEDE DE PRODUCTION D'ENSEMBLES MEMOIRES A SEMICONDUCTEUR SANS COUCHES D'ARRET

(30) Priorität: 30.09.1996 DE 19640273
(43) Veröffentlichungstag der Anmeldung: 28.07.1999
(73) Patentinhaber: Infineon Technologies AG, 81669 München (DE)
(72) Erfinder: SCHINDLER, Günther, D-80802 München (DE); HARTNER, Walter, D-89441 Medlingen (DE); HINTERMAIER, Frank, D-81373 München (DE); MAZURE-ESPEJO, Carlos, D-85604 Zorneding (DE)
(74) Vertreter: Zedlitz, Peter, Dipl.-Inf.
(86) Internationale Anmeldenummer: DE9702032
(87) Internationale Veröffentlichungsnummer: WO9815002

(56) Entgegenhaltungen:
- DE-C- 4 222 467
- US-A- 5 313 089

## Beschreibung

Die Erfindung betrifft ein Verfahren zur Herstellung einer integrierten Halbleiterspeicheranordnung und eine nach dem Verfahren hergestellte Speicheranordnung.

Speicheranordnungen auf Halbleiterbasis bestehen üblicherweise aus einer Anzahl Speicherzellen, die jeweils einen Auswahltransistor und einen mit dem Auswahltransistor verbundenen Speicherkondensator aufweisen. Während eines Herstellverfahrens derartiger Speicheranordnungen werden üblicherweise erste Elektroden über leitenden Verbindungen aufgebracht, wobei jeweils eine der leitenden Verbindungen eine der ersten Elektroden mit jeweils einem der Auswahltransistoren verbindet. Über der ersten Elektrode wird ein Speicherdielektrikum aufgebracht, auf welchem wiederum eine zweite Elektrode aufgebracht wird, so daß die erste und die zweite Elektrode sowie das dazwischenliegende Speicherdielektrikum einen Speicherkondensator bilden, der mit einem der Auswahltransistoren verbunden ist.

Ein derartige Speicheranordnung ist beispielsweise aus dem Dokument JP-A-5-343 615 bekannt. Die bekannte Halbleiterspeicheranordnung besitzt eine erste und zweite Elektrode, die auf der Oberfläche einer Isolationschicht über dem Halbleiterkörper angeordnet sind und die senkrecht zu der Oberfläche der Isolationsschicht stehen.

DE-A-42 22 467 offenbart eine weitere Speicheranordnung.

Eine Verwendung neuartiger ferroelektrischer Materialien als Speicherdielektrikum der Speicherkondensatoren ermöglicht eine Herstellung von Halbleiterspeichern, die ihre in Form von elektrischer Ladung gespeicherte Information nach Wegfall einer Versorgungsspannung nicht verlieren bzw. deren Speicherinhalte nicht in regelmäßigen Abständen aufgrund auftretender Leckströme aufgefrischt werden müssen.

Kritisch bei der Verwendung der meisten der bisher bekannten derartigen ferroelektrischen Materialien ist deren Verarbeitung innerhalb eines Halbleiterprozesses. Eine Abscheidung der meisten derartigen ferroelektrischen Materialien findet bei hohen Temperaturen in einer sauerstoffhaltigen Atmosphäre statt. Die Verwendung derartiger ferroelektrischer Materialien in dem oben beschriebenen Verfahren, bei dem das Speicherdielektrikum über der ersten Elektrode aufgebracht wird, welche sich wiederum über einer leitenden Verbindung zu einem der Auswahltransistoren befindet, hat eine Oxidation der leitenden Verbindung zur Folge, da Sauerstoff während der Abscheidung der ferroelektrischen Materialien durch die erste Elektrode hindurch in Richtung der leitenden Verbindung diffundiert und diese oxidiert. Eine Oxidation der leitenden Verbindung bedeutet eine Unterbrechung der elektrischen Verbindung zwischen Speicherkondensator und Auswahltransistor einer Speicherzelle, so daß diese nicht mehr funktionsfähig ist.

Lösungsansätze zur Vermeidung der Oxidation der leitenden Verbindung während des Abscheidens eines ferroelektrischen Speicherdielektrikums sehen vor, Barrierenschichten zwischen der leitenden Verbindung und der ersten Elektrode aufzubringen, wobei die Barrierenschichten elektrisch leitfähig aber widerstandsfähig gegen Oxidation und das Hindurchdiffundieren von Sauerstoff sein müssen. Nachteilig bei der Verwendung von Barrierenschichten ist die schwierige Suche nach geeigneten Materialien, die sowohl elektrisch leitfähig als auch sauerstoffundurchlässig und widerstandsfähig gegen Oxidation sind und die in geeigneter Weise auf die leitenden Verbindungen aufgebracht werden können.

Die Erfindung hat das Ziel, ein Verfahren zur Herstellung einer integrierten Halbleiterspeicheranordnung zur Verfügung zu stellen, bei dem ferroelektrische Materialien zur Herstellung der Speicherdielektrika der herzustellenden Speicherkondensatoren verwendet werden können und bei dem auf die Verwendung von Barrierenschichten zwischen leitender Verbindung und erster Elektrode verzichtet werden kann, so daß sich insbesondere oben genannte Nachteile nicht ergeben, sowie eine nach dem Verfahren hergestellte Speicheranordnung anzugeben.

Dieses Ziel wird mit einem Verfahren gemäß Anspruch 1 zur Herstellung einer integrierten Halbleiterspeicheranordnung erreicht, das folgende Verfahrensschritte aufweist:
- Bereitstellen einer Anordnung aus Auswahltransistoren mit einem Halbleiterkörper und einer über dem Halbleiterkörper angeordneten Isolationsschicht;
- Erzeugen von Kontaktlöchern in der Isolationsschicht über Source-Gebieten von Auswahltransistoren, die sich innerhalb des Halbleiterkörpers befinden;
- Aufbringen einer Hilfsschicht auf einer im folgenden mit erster Hauptfläche bezeichneten Oberfläche der Isolationsschicht und anschließendes Einbringen von Aussparungen in diese Hilfsschicht;
- Herstellen von ersten Elektroden an Seitenflächen der Aussparungen;
- Aufbringen eines Speicherdielektrikums an den ersten Elektroden;
- Aufbringen einer zweiten Elektrode an freien Flächen des Speicherdielektrikums;
- Entfernen der Hilfsschicht;
- Herstellen einer leitenden Verbindung zwischen jeweils einer der ersten Elektroden und dem Source-Gebiet eines der Auswahltransistoren.

Bei dem erfindungsgemäßen Verfahren zur Herstellung einer Speicheranordnung erfolgt die Herstellung einer leitenden Verbindung zwischen einer der beiden Elektroden, in diesem Fall der ersten Elektrode, und dem Auswahltransistor erst nachdem das Speicherdielektrikum abgeschieden wurde.

Verfahren ist geeignet für die Verwendung beliebiger Dielektrika als Speicherdielektrika von Speicherkondensatoren in integrierten Halbleiterspeicheranordnungen. Es ist insbesondere
geeignet für die Verwendung ferroelektrischer Materialien als Speicherdielektrika, da bei diesem Verfahren oben genannte Probleme, wie die Oxidation der leitenden Verbindung zu den Auswahltransistoren während der Abscheidung des Speicherdielektrikums, nicht auftreten können. Das Verfahren ist weiterhin mit bisher bekannten Methoden zur Herstellung von Speicheranordnungen leicht durchführbar.

Weiterbildungen der Erfindung sind Gegenstand der Unteransprüche.

Für das Herstellen der ersten Elektroden an den Seitenflächen der Aussparungen sind verschiedene Verfahren denkbar. Eine Ausführungsform der Erfindung sieht vor, die ersten Elektroden durch Abscheiden einer ersten Schicht aus Elektrodenmaterial in Richtung der ersten Hauptfläche herzustellen, wobei die erste Schicht anschließend in Abschnitte der Fläche der späteren ersten Elektrode unterteilt wird. Die Unterteilung erfolgt vorzugsweise durch Entfernen der ersten Schicht von parallel zur ersten Hauptfläche verlaufenden Flächen der Hilfsschicht und/oder von freiliegenden Bereichen der ersten Hauptfläche. Freiliegende Bereiche der ersten Hauptfläche können beispielsweise durch die Herstellung von Aussparungen in der Hilfsschicht entstehen, wobei die Hilfsschicht im Bereich der Aussparungen vollständig entfernt ist. Vorzugsweise weisen die Aussparungen einen rechteckförmigen Querschnitt auf, so daß die entstehenden ersten Elektroden annähernd senkrecht auf der ersten Hauptfläche angeordnet sind.

Das Aufbringen des Speicherdielektrikums an den ersten Elektroden und das anschließende Aufbringen der zweiten Elektroden erfolgt vorzugsweise durch aufeinanderfolgendes Abscheiden einer Dielektrikumsschicht und einer zweiten Schicht aus Elektrodenmaterial in Richtung der ersten Hauptfläche, wobei die beiden Schichten anschließend vorzugsweise von den parallel zur ersten Hauptfläche verlaufenden Flächen der Hilfsschicht, die sich außerhalb der Aussparungen befinden, entfernt werden. Die Entfernung der beiden Schichten von den parallel zur ersten Hauptfläche verlaufenden Flächen der Hilfsschicht ist notwendig, um in einem nächsten Verfahrensschritt die Hilfsschicht entfernen zu können.

Um die aus erster Elektrode, Speicherdielektrikum und zweiter Elektrode bestehenden Speicherkondensatoren, die bei Verwendung von Aussparungen mit rechteckigem Querschnitt annähernd senkrecht auf der ersten Hauptfläche stehen, nach dem Entfernen der Hilfsschicht zu stabilisieren, ist in einer weiteren Ausführungsform der Erfindung vorgeschlagen, eine Stabilisierungsschicht in Richtung der ersten Hauptfläche abzuscheiden, die anschließend teilweise, zusammen mit der Dielektrikumsschicht und der zweiten Schicht, von parallel zur ersten Hauptfläche verlaufenden Flächen der Hilfsschicht entfernt wird. Reste der Stabilisierungsschicht verbleiben nach der Entfernung von Teilen der Dielektrikumsschicht und der zweiten Schicht in den Aussparungen zurück.

Das Entfernen der Dielektrikumsschicht, der zweiten Schicht aus Elektrodenmaterial, sowie gegebenenfalls der Stabilisierungsschicht von parallel zu der ersten Hauptfläche verlaufenden Flächen der Hilfsschicht ist notwendig, um in einem nächsten Verfahrensschritt die Hilfschicht vollständig von der ersten Hauptfläche und aus den Kontaktlöchern entfernen zu können.

Nach Entfernung der Hilfsschicht liegen die Source-Gebiete der Auswahltransistoren frei und können mit den jeweiligen ersten Elektroden verbunden werden. Eine Ausführungsform der Erfindung sieht vor, daß das Herstellen der leitenden Verbindung durch Ausfüllen eines innerhalb der ersten Elektroden befindlichen Bereiches mit einem leitfähigen Material erfolgt.

Die ferroelektrischen Eigenschaften der meisten der bisher bekannten ferroelektrischen Materialien, die nach einer Ausführungsform der Erfindung als Speicherdielektrikum in Frage kommen sind temperaturabhängig. Diese ferroelektrischen Materialien verhalten sich unterhalb einer für sie charakteristischen Temperatur ferroelektrisch, während sie sich oberhalb dieser charakteristischen Temperatur paraelektrisch verhalten, wobei die Dielektrizitätskonstante im paraelektrischen Zustand wesentlich höher ist als die Dielektrizitätskonstanten bisher verwendeter Speicherdielektrika. Die Temperatur, unterhalb derer sich ferroelektrische Eigenschaften einstellen, ist bei einigen ferroelektrischen Materialien sehr niedrig, so daß aus technischer Sicht eine Verwendung dieser ferroelektrischen Materialien nur im paraelektrischen Zustand in Frage kommt, wobei deren Dielektrizitätskonstante im paraelektrischen Zustand jeweils über 10, vorzugsweise über 100 beträgt.

Eine Ausführungsform der Erfindung sieht vor, Materialien als Speicherdielektrika zu verwenden, deren Dielektrizitätskonstante jeweils größer als 10 ist, wobei derartige Materialien beispielsweise oben genannte ferroelektrische Materialien sein können, die oberhalb der für sie charakteristischen Temperatur verwendet werden.

Eine Ausführungsform der Erfindung sieht vor, oxidische Dielektrika als Speicherdielektrika zu verwenden. Zur Klasse dieser Substanzen gehören beispielsweise SBTN SrBi₂(Ta₁₋ ₓNbₓ)₂O₉, SBT SrBi₂Ta₂O₉, PZT (Pb, Zr)TiO₃, BST (Ba, Sr)TiO₃ oder ST SrTiO₃. Die Formel (Pb, Zr)TiO₃ steht für PbₓZr₁₋ ₓTiO₃. Der Anteil an Pb und Zr bei diesem Substrat kann variieren, wobei das Verhältnis aus Pb und Zr das Temperaturverhalten dieses Dielektrikums maßgeblich bestimmt, d. h. die Temperatur bestimmt, unterhalb deren das Substrat ferroelektrische Eigenschaften bzw. oberhalb derer das Substrat paraelektrische Eigenschaften aufweist. Die Formel (Ba, Sr)TiO₃ steht für BaₓSr₁₋ₓTiO₃, wobei bei diesem Substrat das Temperaturverhalten über das Verhältnis von Ba zu Sr maßgeblich bestimmt werden kann. Die Liste der genannten Substanzen ist keineswegs vollständig. Die Auswahl einer der Substanzen als Speicherdielektrikum hängt maßgeblich von Verarbeitungsfaktoren während des Herstellverfahrens aber auch von Faktoren während des Einsatzes der Halbleiterspeicheranordnung, beispielsweise der Umgebungstemperatur ab.

Halbleiterspeicheranordnungen, die nach dem erfindungsgemäßen Verfahren hergestellt werden, sind Gegenstand der Unteransprüche 9 bis 12.

Die Erfindung wird nachfolgend im Zusammenhang mit Ausführungsbeispielen anhand von Figuren näher erläutert. Es zeigen:
- Fig. 1: ein Verfahren nach der Erfindung zur Herstellung einer Speicheranordnung,
- Fig. 2: eine nach dem Verfahren hergestellte Speicheranordnung in Draufsicht.

In den nachfolgenden Figuren bezeichnen, sofern nicht anders angegeben, gleiche Bezugszeichen gleiche Teile mit gleicher Bedeutung.

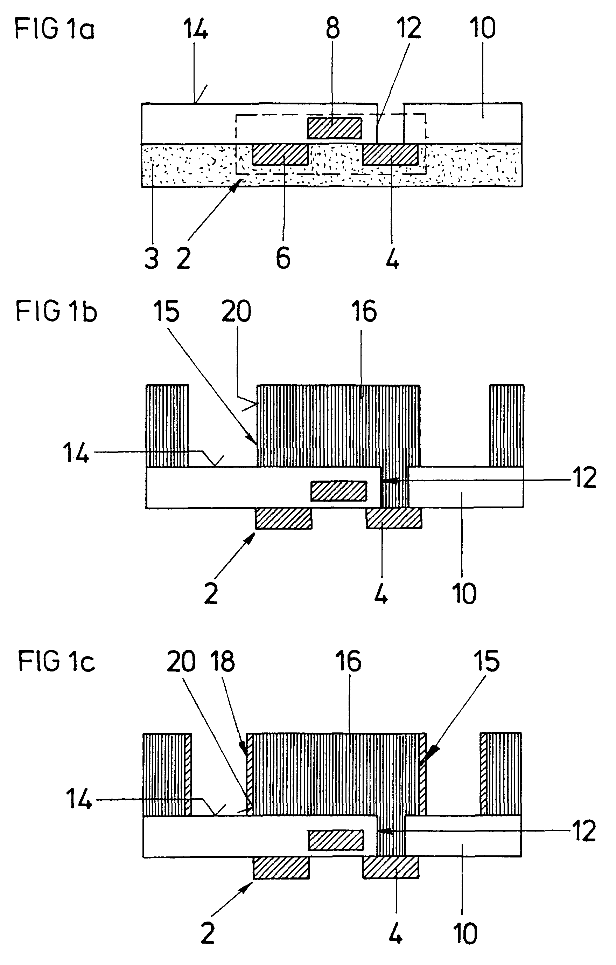

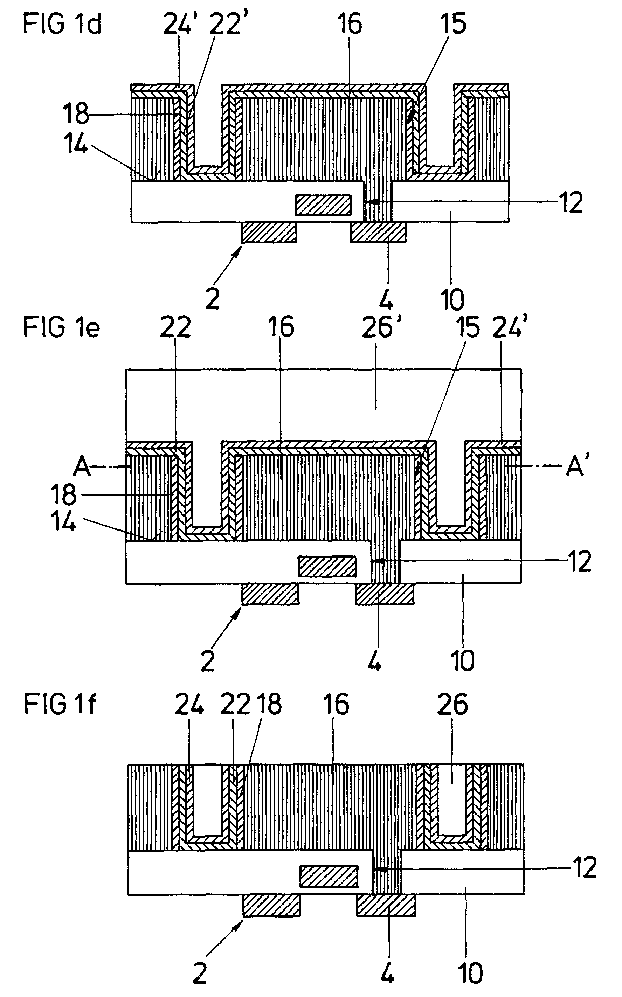

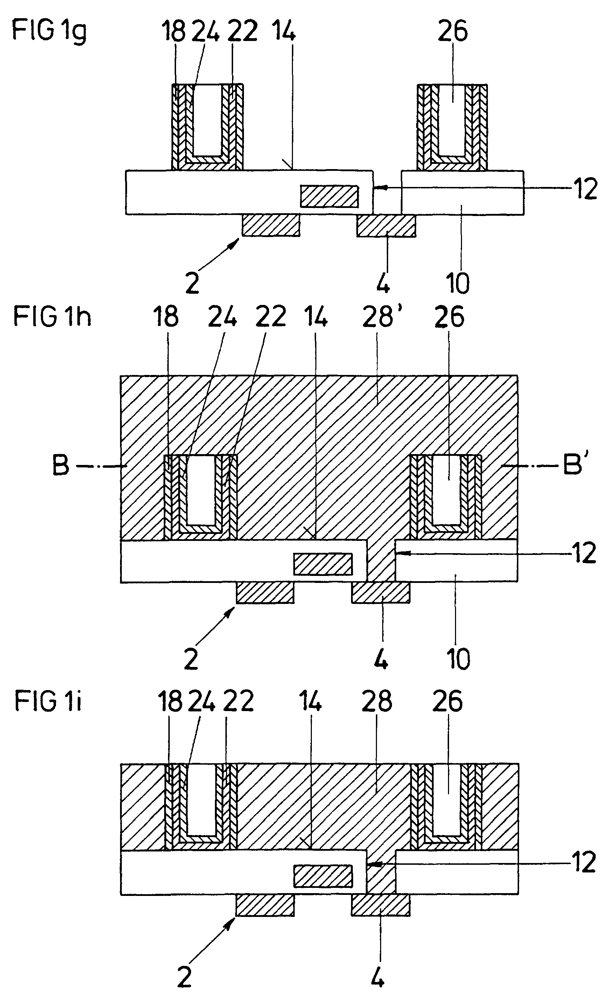

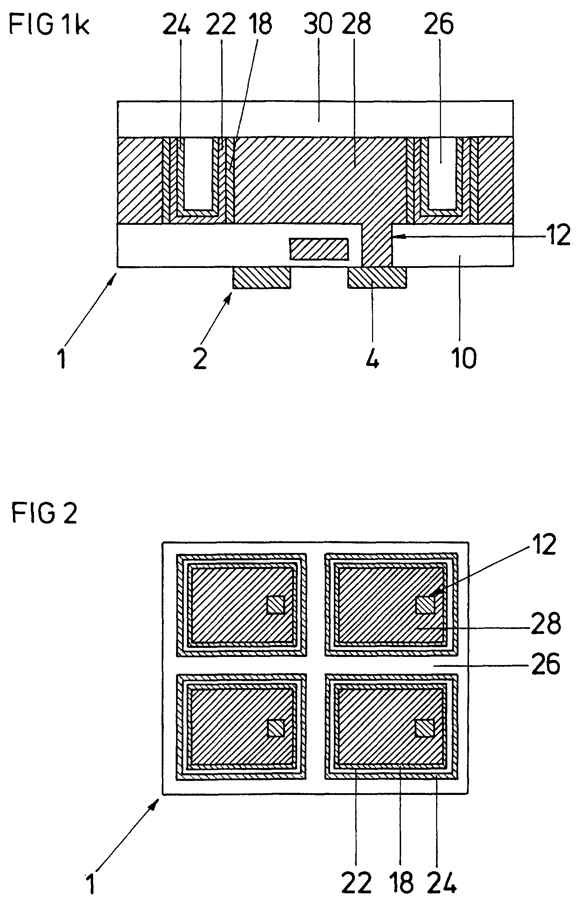

In Figur 1 ist ein Verfahren nach der Erfindung zur Herstellung einer Speicheranordnung anhand mehrerer in den Figuren 1a bis 1k dargestellter Verfahrensschritte erläutert.

Figur 1a zeigt einen Querschnitt durch einen Ausschnitt einer Anordnung aus Auswahltransistoren 2, die einen Halbleiterkörper 3 aufweist, über dem eine Isolationsschicht 10 angeordnet ist. Ein Drain-Gebiet 6 und ein Source-Gebiet 4 des dargestellten Auswahltransistors 2 befinden sich in dem Halbleiterkörper 3, ein Gate 8 des Auswahltransistors befindet sich in der darüber liegenden Isolationsschicht 10. Die Source- und Drain-Gebiete 4, 6 können beispielsweise aus komplementär zum Leitungstyp des Halbleiterkörpers 3 dotierten Bereichen des Halbleiterkörpers 3 bestehen. Ein in die Isolationsschicht 10 eingebrachtes Kontaktloch über dem Source-Gebiet 4 ermöglicht das spätere Herstellen einer leitenden Verbindung zwischen dem Source-Gebiet 4 des Auswahltransistors 2 und auf der ersten Hauptfläche der Isolationsschicht 10 angeordneten Elektroden. In den folgenden Figuren werden auf die explizite Darstellung des Halbleiterkörpers 3 und auf die Bezugszeichen für Drain-Gebiet 6 und Gate 8 aus Gründen der Übersichtlichkeit verzichtet. Weiterhin wird in den Figuren auf eine Darstellung zusätzlicher Verdrahtungen, wie Wort- und Bit-Leitungen, die bei derartigen Halbleiterspeicheranordnungen üblicherweise eine Anzahl Auswahltransistoren 2 miteinander verbinden, verzichtet. Derartige Anordnungen aus Auswahltransistoren 2 können komplett vorgefertigt sein und für verschiedene Verfahren zur Herstellung von Speicheranordnungen mit unterschiedlichsten Speicherkondensatorgeometrien verwendet werden.

Figur 1b zeigt die in Figur 1a dargestellte Anordnung aus Auswahltransistoren 2 nach einem weiteren Verfahrensschritt, bei dem über der ersten Hauptfläche 14 der Isolationsschicht 10 eine Hilfsschicht 16 aufgebracht wurde, die Aussparungen 15 aufweist. Die in dem Beispiel dargestellten Aussparungen besitzen einen rechteckförmigen Querschnitt und können beispielsweise durch anisotropes Ätzen der Hilfsschicht 16 hergestellt werden. Als Material für die Hilfsschicht kann beispielsweise Siliziumnitrid Si₃N₄ verwendet werden. Wie dargestellt, füllt die Hilfsschicht auch die Kontaktlöcher 12 über den Source-Gebieten 4 der Auswahltransistoren 2 aus. Im Bereich der Aussparungen 15 liegen in dem dargestellten Beispiel Bereiche der ersten Hauptfläche 14 der Isolationsschicht 10 frei. Es ist jedoch auch denkbar, Aussparungen 15 vorzusehen, deren Tiefe geringer ist als die Dicke der Hilfsschicht 16, so daß die erste Hauptfläche 14 vollständig überdeckt ist.

Figur 1c zeigt die in Figur 1b dargestellte Anordnung nach weiteren Verfahrensschritten, bei denen erste Elektroden 18 an Seitenflächen 20 der Hilfsschicht 16 aufgebracht wurden. Die Herstellung der ersten Elektroden kann beispielsweise durch Abscheiden einer ersten Schicht aus Elektrodenmaterial in Richtung der ersten Hauptfläche 14 erfolgen, wobei die ersten Elektroden 18 durch Entfernen der ersten Schicht von parallel zu der ersten Hauptfläche 14 verlaufenden Flächen der Hilfsschicht 16 und von freiliegenden Bereichen der ersten Hauptfläche erfolgen kann. Das Entfernen der ersten Schicht von den angesprochenen Bereichen kann beispielsweise durch anisotopes Ätzen der ersten Schicht aus Elektrodenmaterial erfolgen, so daß die erste Schicht lediglich an den annähernd senkrecht zur ersten Hauptfläche 14 verlaufenden Seitenflächen 20 der Hilfsschicht erhalten bleibt, um die ersten Elektroden 18 zu bilden. Als Material für die erste Schicht aus Elektrodenmaterial kann beispielsweise Platin verwendet werden.

Figur 1d zeigt die in Figur 1c dargestellte Anordnung nach einem weiteren Verfahrensschritt, in dem eine Dielektrikumsschicht 22' und anschließend eine zweite Schicht 24' aus Elektrodenmaterial über der Anordnung abgeschieden wurde. In einem nächsten Verfahrensschritt wurde eine Stabilisierungsschicht 26' über der so entstandenen Anordnung abgeschieden, so daß sich die in Figur le im Querschnitt dargestellte Anordnung ergibt. Als Material für die Stabilisierungsschicht 26' kann beispielsweise Polysilizium oder auch ein isolierendes Material verwendet werden.

Figur 1f zeigt die in Figur le dargestellte Anordnung nach einer Entfernung der oberhalb der in Figur le eingezeichneten Linie A-A' gelegenen Schichten der Anordnung. Wie in Figur 1f dargestellt, liegt nach dieser Entfernung die Hilfsschicht 16 nach oben frei und die Dielektrikumsschicht 22', die zweite Schicht 24' aus Elektrodenmaterial und die Stabilisierungsschicht 26' sind außerhalb der Aussparungen 15 von parallel zu der ersten Hauptfläche verlaufenden Flächen der Hilfsschicht 16 entfernt. Die Entfernung dieser Schichten kann beispielsweise durch ein CMP-Verfahren (CMP= Chemical Mechanical Polishing) durchgeführt werden. Wie in Figur le dargestellt, ist die Linie AA' so gewählt, daß bei dem Entfernen der beschriebenen Schichten auch ein geringer Teil der Hilfsschicht 16 entfernt wird. Somit soll gewährleistet sein, daß trotz Unebenheiten die beschriebenen Schichten vollständig von den gewünschten Bereichen entfernt werden. Die in den Aussparungen 15 verbleibenden Teile der Dielektrikumsschicht 22', der zweiten Schicht 24 aus Elektrodenmaterial und der Stabilisierungsschicht 26', werden im folgenden entsprechend der genannten Reihenfolge als Speicherdielektrikum 22, als zweite Elektrode 24 und als Stabilisierung 26 bezeichnet.

Figur 1g zeigt die in Figur 1f dargestellte Anordnung nach einem weiteren Verfahrensschritt, bei dem die Hilfsschicht 16 komplett von der ersten Hauptfläche 14 und aus den Kontaktlöchern 12 entfernt wurde. In dieser Figur wird die Funktion der Stabilisierungen 26 deutlich, die die auf der ersten Hauptfläche 14 verbleibenden Speicherkondensatoren, die aus erster Elektrode 18, Speicherdielektrikum 22 und zweiter Elektrode 24 bestehen, mechanisch stabilisieren.

Figur 1h zeigt die beschriebene Anordnung nach einem weiteren Verfahrensschritt, bei dem eine dritte Schicht 28' aus leitendem Material, beispielsweise Polysilizium, abgeschieden wurde. Funktion des leitenden Materials ist die Herstellung einer leitenden Verbindung zwischen dem Source-Gebiet 4 des Auswahltransistors und der ersten Elektrode 18 des Speicherkondensators. In einem nächsten Verfahrensschritt muß die dritte Schicht 28' aus leitendem Material so weit entfernt werden, daß nur jeweils einer der Auswahltransistoren 2 mit jeweils einer der ersten Elektroden 18 verbunden ist. Dies kann beispielsweise unter Verwendung eines CMP-Verfahrens geschehen, womit die dritte Schicht 28' soweit zurückgeätzt wird, bis deren Höhe die Höhe der ersten Elektroden 18 nicht mehr überschreitet.

In dem dargestellten Beispiel erfolgt die Rückätzung bis zu einer in Fig. 1h eingezeichneten Linie BB', die wie ersichtlich unterhalb der Höhe der ersten Elektroden 18 endet, so daß bei dem Ätzverfahren auch geringe Teile der Speicherkondensatoren entfernt werden können. Somit ist sichergestellt, daß eine leitende Verbindung 28 entsteht, die jeweils nur eine der ersten Elektroden 18 mit dem Source-Gebiet 4 eines der Auswahltransistoren 2 verbindet, wie in Fig. 1i dargestellt.

Fig. 1k zeigt die beschriebene Anordnung nach einem weiteren Verfahrensschritt, bei dem eine zweite Isolationsschicht 30 über der Anordnung abgeschieden wurde. Die Kapazität der in der Halbleiterspeicheranordnung verwendeten Speicherkondensatoren ist proportional zu der Fläche der ersten Elektroden 18. In dem dargestellten Beispiel wird offensichtlich, daß die Kapazität der Speicherkondensatoren durch Erhöhen der ersten Elektroden 18 weiter gesteigert werden kann.

Fig. 2 zeigt einen Ausschnitt einer nach dem erfindungsgemäßen Verfahren hergestellten Halbleiterspeicheranordnung in Draufsicht, wobei der in Fig. 2 dargestellte Ausschnitt vier Speicherzellen zeigt. In der dargestellten Draufsicht wird deutlich, daß die ersten Elektroden 18 einen Bereich der ersten Hauptfläche 14 der Isolationsschicht 10 umfassen, in dem sich jeweils das Kontaktloch 12 befindet, über das eine Verbindung zwischen der ersten Elektrode 18 und dem unterhalb des Kontaktlochs 12 befindlichen Source-Gebiet 4 eines der Auswahltransistoren 2 hergestellt wird. Weiterhin in Fig. 2 dargestellt, ist die Stabilisierung 26, die sich zwischen den Speicherkondensatoren befindet.

## Patentansprüche

1. Verfahren zur Herstellung einer integrierten Halbleiterspeicheranordnung, das folgende Verfahrensschritte aufweist:
- Bereitstellen einer Anordnung aus Auswahltransistoren (2) mit einem Halbleiterkörper (3) und einer über dem Halbleiterkörper (3) angeordneten Isolationsschicht (10) ;
- Erzeugen von Kontaktlöchern (12) in der Isolationsschicht (10) über Source-Gebieten (4) der Auswahltransistoren (2);
- Aufbringen einer Hilfsschicht (16) auf einer Oberfläche (14) der Isolationsschicht (10) und anschließendes Einbringen von Aussparungen (15) in diese Hilfsschicht (16);
- Herstellen von ersten Elektroden (18) an Seitenflächen (20) der Aussparungen (15);
- Aufbringen eines Speicherdielektrikums (22) an den ersten Elektroden (18);
- Aufbringen einer zweiten Elektrode (24) an freien Flächen des Speicherdielektrikums (22) ;
- Entfernen der Hilfsschicht (16);
- Herstellen einer leitenden Verbindung (28) zwischen jeweils einer der ersten Elektroden (18) und dem Source-Gebiet (4) eines der Auswahltransistoren (2).

2. Verfahren nach Anspruch 1, **dadurch gekennzeichnet, daß** das Herstellen der ersten Elektroden (18) durch Abscheiden einer ersten Schicht aus Elektrodenmaterial erfolgt, die anschließend von parallel zur Oberfläche (14) verlaufenden Flächen der Hilfsschicht und/oder von freiliegenden Bereichen der Oberfläche (14) entfernt wird.

3. Verfahren nach Anspruch 1 oder 2, **dadurch gekennzeichnet, daß** das Aufbringen des Speicherdielektrikums (22) und die Herstellung der zweiten Elektroden durch aufeinanderfolgendes Abscheiden einer Dielektrikumsschicht (22') und einer zweiten Schicht (24') aus Elektrodenmaterial in Richtung der ersten Hauptfläche (14) erfolgt, wobei die beiden Schichten (22', 24') anschließend außerhalb der Aussparungen (15) von den parallel zur Oberfläche (14) verlaufenden Flächen der Hilfsschicht (16) entfernt werden.

4. Verfahren nach Anspruch 3, **dadurch gekennzeichnet, daß** vor dem Entfernen der beiden Schichten (22', 24') von den parallel zur Oberfläche (14) verlaufenden Flächen der Hilfsschicht (16) eine Stabilisierungsschicht (26') über der zweiten Schicht (24') abgeschieden wird, die beim Entfernen der beiden Schichten (22', 24') teilweise entfernt wird.

5. Verfahren nach einem der vorangehenden Ansprüche, **dadurch gekennzeichnet, daß** das Herstellen der leitenden Verbindung (28) durch Ausfüllen eines innerhalb der ersten Elektroden (18) befindlichen Bereiches mit einem leitfähigen Material erfolgt.

6. Verfahren nach einem der vorangehenden Ansprüche, **dadurch gekennzeichnet, daß** das Speicherdielektrikum ferroelektrische Eigenschaften aufweist.

7. Verfahren nach einem der vorangehenden Ansprüche, **dadurch gekennzeichnet, daß** das Speicherdielektrikum (22) eine Dielektrizitätskonstante größer als 10 aufweist.

8. Verfahren nach einem der vorangehenden Ansprüche, **dadurch gekennzeichnet, daß** das Speicherdielektrikum (22) ein oxidisches Dielektrikum, insbesondere SBTN SrBi₂(Ta₁₋ₓNbₓ)₂O₉, SBT SrBi₂Ta₂O₉, PZT (Pb, Zr)TiO₃, BST (Ba, Sr)TiO₃ oder ST SrTiO₃ ist.

## Claims

1. Process for producing an integrated semiconductor memory arrangement, having the following process steps:
- provision of an arrangement of selection transistors (2) having a semiconductor body (3) and an insulation layer (10) arranged above the semiconductor body (3);
- production of contact holes (12) in the insulation layer (10) above source regions (4) of the selection transistors (2);
- application of an auxiliary layer (16) on a surface (14) of the insulation layer (10) and subsequent making of cutouts (15) in this auxiliary layer (16);
- production of first electrodes (18) on side faces (20) of the cutouts (15);
- application of a storage dielectric (22) on the first electrodes (18);
- application of a second electrode (24) on free areas of the storage dielectric (22);
- removal of the auxiliary layer (16);
- production of a conductive connection (28) between a respective one of the first electrodes (18) and the source region (4) of one of the selection transistors (2).

2. Process according to Claim 1, **characterized in that** the first electrodes (18) are produced by depositing a first layer of electrode material which is subsequently removed from areas of the auxiliary layer which run parallel to the surface (14) and/or from exposed regions of the surface (14).

3. Process according to Claim 1 or 2, **characterized in that** the storage dielectric (22) is applied, and the second electrodes are produced, by successively depositing a dielectric layer (22') and a second layer (24') of electrode material in the direction of the first main area (14), the two layers (22', 24') subsequently being removed outside the cutouts (15) from the areas of the auxiliary layer (16) which run parallel to the surface (14).

4. Process according to Claim 3, **characterized in that**, before the two layers (22', 24') are removed from the areas of the auxiliary layer (16) which run parallel to the surface (14), a stabilization layer (26') is deposited above the second layer (24') and is partially removed when the two layers (22', 24') are removed.

5. Process according to one of the preceding claims, **characterized in that** the conductive connection (28) is produced by filling a region situated within the first electrodes (18) with a conductive material.

6. Process according to one of the preceding claims, **characterized in that** the storage dielectric has ferroelectric properties.

7. Process according to one of the preceding claims, **characterized in that** the storage dielectric (22) has a dielectric constant higher than 10.

8. Process according to one of the preceding claims, **characterized in that** the storage dielectric (22) is an oxide-containing dielectric, in particular SBTN SrBi₂ (Ta₁₋ₓNbₓ)₂O₉, SBT SrBi₂Ta₂O₉, BST (Ba, Sr)TiO₃ or ST SrTiO₃.

## Revendications

1. Procédé de fabrication d'un dispositif intégré de mémoire à semi-conducteur, qui comporte les étapes opératoires suivantes :
- on prend un dispositif constitué de transistors (2) de sélection comportant un élément (3) semi-conducteur et une couche (10) d'isolement disposée au-dessus de l'élément (3) semi-conducteur ;
- on produit des trous (12) métallisés dans la couche (10) d'isolement au-dessus de zones (4) de source des transistors (2) de sélection;
- on dépose une couche (16) auxiliaire sur une surface (14) de la couche (10) d'isolement et on ménage ensuite des évidements (15) dans cette couche (16) auxiliaire ;
- on produit des premières électrodes (18) sur des faces (20) latérales des évidements (15) ;
- on dépose un diélectrique (22) de stockage sur les premières électrodes (18) ;
- on dépose une deuxième électrode (24) sur des faces libres du diélectrique (22) de stockage ;
- on enlève la couche (16) auxiliaire ;
- on produit une liaison (28) conductrice entre respectivement l'une des premières électrodes (18) et la zone (4) de source de l'un des transistors (2) de sélection.

2. Procédé suivant la revendication 1, **caractérisé en ce que** la fabrication des premières électrodes (18) s'effectue par dépôt d'une première couche en un matériau d'électrode que l'on enlève ensuite de faces de la couche auxiliaire s'étendant parallèlement à la surface (14) et/ou de zones dégagées de la surface (14).

3. Procédé suivant la revendication 1 ou 5, **caractérisé en ce que** le dépôt du diélectrique (22) de stockage et la fabrication des deuxièmes électrodes s'effectue par dépôt successif d'une couche (22') de diélectrique et d'une deuxième couche (24') en matériau d'électrode en direction de la première face (14) principale, les deux couches (22', 24') étant enlevées ensuite à l'extérieur des évidements (15) des faces de la couche (16) auxiliaire s'étendant parallèlement à la surface (14).

4. Procédé suivant la revendication 3, **caractérisé en ce que**, avant l'enlèvement des deux couches (22', 24') des faces de la couche (16) auxiliaire s'étendant parallèlement à la surface (14), on dépose sur la deuxième couche (24') une couche (26') de stabilisation que l'on enlève en partie lors de l'enlèvement des deux couches (22', 24').

5. Procédé suivant l'une des revendications précédentes, **caractérisé en ce que** la production de la liaison (28) conductrice s'effectue en remplissant d'un matériau conducteur une zone se trouvant à l'intérieur des premières électrodes (18).

6. Procédé suivant l'une des revendications précédentes, **caractérisé en ce que** le diélectrique de stockage a des propriétés ferroélectriques.

7. Procédé suivant l'une des revendications précédentes, **caractérisé en ce que** le diélectrique (22) de stockage a une constante diélectrique supérieure à 10.

8. Procédé suivant l'une des revendications précédentes, **caractérisé en ce que** le diélectrique (22) de stockage est un diélectrique oxydé, notamment SBTN SrBi₂(Ta₁₋ₓNbₓ)₂O₉, SBT SrBi₂Ta₂O₉, PZT (Pb, Zr)TiO₃, BST (Ba, Sr)TiO₃ ou ST SrTiO₃.
